# EUROPEAN PATENT APPLICATION

(11) **EP 1 523 046 A1**
(43) Date of publication of application: **13.04.2005**
(21) Application number: 04077568.6
(22) Date of filing: 16.09.2004
(51) Int. Cl.: H01L 31/0203

(54) **Integrated optical filter**

(30) Priority: 06.10.2003 US 679752
(71) Applicant: Delphi Technologies, Inc., Troy, MI 48007 (US)
(72) Inventor: Burns, Jeffrey H., Kokomo, IN 46902 (US)
(74) Representative: Denton, Michael John

(57) **Abstract**

The present invention involves an optical sensor assembly (10, 100) including an optically transmissive substrate (12, 102) and an integrated circuit (16) having an optical imaging element (24). The optically transmissive substrate includes an integral filter element and the integrated circuit includes an optical imaging element which is located on a face (26) of the integrated circuit facing the substrate. The filter material may be dispersed, embedded, or otherwise formed within the substrate, or provided as a thin film layer (104) on a surface of the substrate.

## Description

### TECHNICAL BACKGROUND

The present invention relates to packaging of optical sensors. More particularly, the invention relates to the packaging of optical sensing integrated circuits and optical filters.

### BACKGROUND OF THE INVENTION

A variety of optical sensors employ a radiation sensing element for detecting visible or invisible light, such as a thermopile, fabricated in or on the surface of a semiconductor substrate. The semiconductor may be placed within a protective package, such as a TO-x type can, with a window that allows radiation to reach the sensing element. A drawback of this type of packaging approach is that the package is not suitable for surface mounting and may be too large for some applications, especially applications requiring lenses, filters, or other optical elements between the radiation source and sensor.

An optical sensor package which couples an optical sensor semiconductor directly to a substrate, in this case by using solder bumps to couple the semiconductor to a chip carrier, is disclosed in U.S. Patent Application Publication U.S. 2003/0146384, "Surface-Mount Package for an Optical Sensing Device and Method of Manufacture," published August 7, 2003, Logsdon et al., assigned to the assignee of the present invention, the disclosure of which is hereby incorporated herein by reference. Logsdon discloses an optical sensing semiconductor that is electrically coupled to the chip carrier on a side of the semiconductor opposite the optical sensing element. The chip carrier is capped by a transparent substrate, such as monocrystallographic silicone, which provides an environmental barrier while allowing radiation to pass through to the sensing element.

Another known optical sensor package includes an optical sensor formed on a first substrate and flip chip bonded to a second substrate. The second substrate includes a transparent section which is aligned with the optical sensor, and allows light to pass through the second substrate and contact the optical sensor.

Other known assemblies include an optical mount attached to an optical sensor package. The optical mount provides support for a lens and a filter for selective transmission and focusing of radiation directed to the optical sensing element. However, space constraints in some applications cause such an arrangement to be undesirable because of the back focal length between the lens and filter and the optical sensing element. Additionally, multiple optical elements may each cause reflections and other losses that reduce the radiation reaching the sensing element.

What is needed is an optical sensing package which includes an optical sensor and filter while requiring a smaller parts count and smaller physical package, including the back focal length.

### SUMMARY OF THE INVENTION

An optical sensor assembly is provided including an optically transmissive substrate and an integrated circuit having an optical imaging element. The optically transmissive substrate includes an integral filter element and the integrated circuit includes an optical imaging element which is located on a face of the integrated circuit facing the substrate. The filter material may be dispersed, embedded, or otherwise formed within the substrate, or provided as a thin film layer on a surface of the substrate.

The optically transmissive substrate may include a circuit member defining electrically conductive leads to which electrically conductive pads of the optical imaging element are coupled, for example, by conductive bumps used for flip chip mounting the integrated circuit to the substrate. An exemplary arrangement of chip flip mounting an integrated circuit to a substrate is disclosed by U.S. Patent Application 10/317,520, "Optical Information Processing Circuit Assembly," filed December 12, 2002, by Tan et al, assigned to the assignee of the present invention, the disclosure of which is hereby incorporated herein by reference.

A lens mount supporting a lens or other optical element may be coupled to the substrate on a surface opposite the integrated circuit. The filter material and transmissive properties of the substrate may be incorporated throughout the substrate, or alternatively, may be limited to a region through which radiation is transmitted to the optical imaging element of the integrated circuit. The substrate or thin film layer on the substrate may also include antireflective material or properties.

One form of the invention provides an optical sensor circuit assembly, including an optically transmissive substrate including filter material and an optical imaging element coupled to the substrate.

Another form of the present invention provides an optical sensor circuit assembly, including an optically transmissive substrate, a thin film optical material coupled to the substrate, and an integrated circuit having a surface with an optical imaging element, the surface coupled with one of the substrate and the optical material.

Yet another form of the invention provides a method of assembling an optical sensor assembly, including the steps of providing an optically transmissive substrate; associating at least one of a filter material and an antireflective material with the optically transmissive substrate; and coupling an integrated circuit including an optical imaging element with the optically transmissive substrate, and positioning the integrated circuit so that the optical imaging element faces the substrate.

Advantageously, the present invention provides an optical sensing package having a small parts count and a small physical package, including a short back focal length between a lens or other optical element and the optical sensing element. Additionally, the present invention requires few optical elements, thereby reducing radiation losses and reflections.

### BRIEF DESCRIPTION OF THE DRAWINGS

The present invention will now be described, by way of example, with reference to the accompanying drawings, in which:
Fig. 1 is a cross-sectional view of a first exemplary optical sensor assembly according to the present invention; and
Fig. 2 is a cross-sectional view of a second exemplary optical sensor assembly according to the present invention.

Corresponding reference characters indicate corresponding parts throughout the several views. Although the drawings represent embodiments of the present invention, the drawings are not necessarily to scale and certain features may be exaggerated in order to better illustrate and explain the present invention. The exemplifications set out herein illustrate embodiments of the invention and such exemplifications are not to be construed as limiting the scope of the invention in any manner.

### DESCRIPTION OF INVENTION

The embodiments disclosed below are not intended to be exhaustive or limit the invention to the precise forms disclosed in the following detailed description. Rather, the embodiments are chosen and described so that others skilled in the art may utilize their teachings.

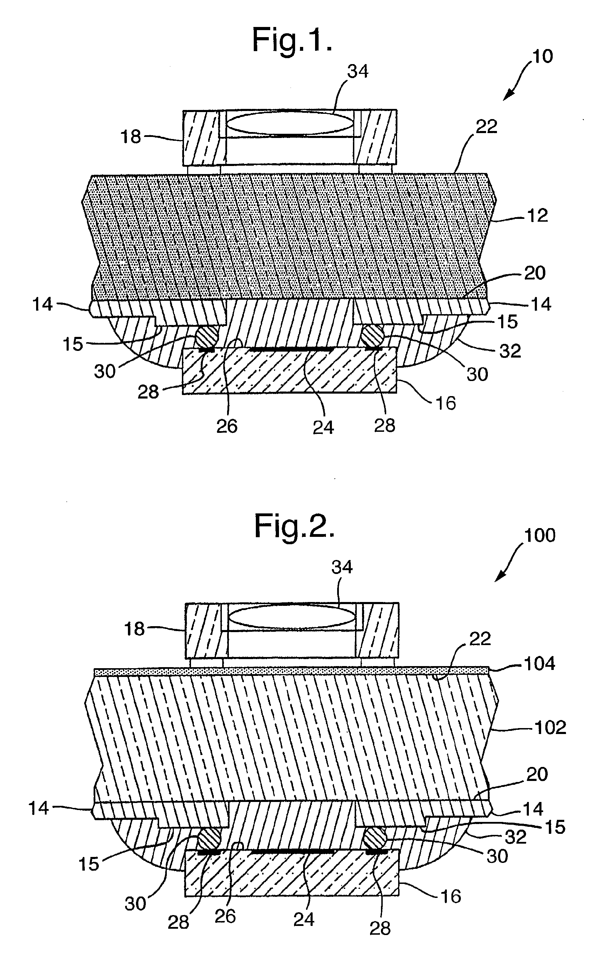

Fig. 1 shows a first exemplary optical sensor assembly 10 which includes optically transmissive substrate 12 and optical integrated circuit 16. Substrate 12 may also include circuit member 14 coupled to first surface 20 of substrate 12. Lens mount 18 may be coupled to second surface 22 of substrate 12.

In first exemplary embodiment 10, optically transmissive substrate 12 is formed of transparent, optical quality glass which has been prepared with a filter material. The filter material may be selected to restrict the transmissivity of optically transmissive substrate 12 to a particular desired range of wavelengths. Thus, light or other electromagnetic radiation outside the desired wavelength range will be partially or fully blocked by the selected filter material. The filter material may be dispersed evenly throughout substrate 12, embedded within a particular location or portion of substrate 12, for example, in a portion generally aligned with integrated circuit 16, or otherwise provided integral with optically transmissive substrate 12. Optically transmissive substrate 12 may be an optical quality glass having integral filter material, for example, exemplary substrate which transmits IR and blocks visible light is Part No. RG-830 available from SCHOTT Glas Hattenbergstasse of Mainz, Germany. Alternatively, substrate 12 may be formed of, or include, other optically transmissive materials, including but not limited to optical quality plastics and fused silica. Substrate 12 may be optically transmissive throughout, or may be optically transmissive in a region generally aligned with integrated circuit 16.

Integrated circuit 16 comprises a semiconductor substrate having an optical imaging circuit or other optical imaging element 24 located on face 26 of integrated circuit 16. Optical imaging element 24 provides sensing of radiation, for example, sensing of visible or infrared light. Optical imaging element 24 may consist of a simple light detector, a complex multiple pixel imager, or other optical sensing elements. Additionally, face 26 of integrated circuit 16 also includes electrically conductive pads 28 for electrically coupling optical imaging element 24 to circuit members 14.

Circuit members 14 may include a resiliently compressible circuit, conductive film, adhesive layer, and/or other electrically conductive printed or other circuit members that are coupled to first surface 20 of substrate 12. Circuit members 14 may include electrically conductive leads 15, as shown in Fig. 1

Conductive bumps 30 located between integrated circuit 16 and optically transmissive substrate 12 provide electrical conductivity and bonding of electrically conductive pads 28 to electrically conductive leads 15. Conductive bumps 30 may be, for example, solder or other conductive material which may be electrically and mechanically attached by thermocompression bonding, reflow, or other such known processes, for example, flip chip mounting.

Optically transmissive medium 32 may be provided between integrated circuit 16 and optical transmissive substrate 12. Medium 32 may also environmentally seal face 26 of integrated circuit 16 and the electrical connections formed by circuit members 14, electrically conductive leads 15, electrically conductive pads 28, and conductive bumps 30. Medium 32 may also reduce reflective losses between substrate 12 and optical imaging circuit 24 and match the index of refraction of one of the other elements, for example, substrate 12. Medium 32 may also act provide an underfill, encapsulant, thermal transient suppression, or other property typically provided for semiconductors or at semiconductor and substrate junctions. Optically transmissive medium 26 may include, for example, Part No. CNB 753-39, a nonconductive paste available from Dexter Corporation of Windsor Lock, Connecticut.

Lens mount 18 may be coupled to second surface 22 of substrate 12. Lens mount 18 may provide support for lens 34 or other optical elements associated with first exemplary optical sensor assembly 10. Lens mount 18 may be located so that lens 34 is optically aligned with optical imaging element 24.

Fig. 2 illustrates second exemplary optical sensor assembly 100. Second exemplary assembly 100 may comprise the same or similar elements and arrangements as first exemplary assembly 10, including integrated circuit 16 having optical imaging element 24 flip chip mounted to circuit members 14 via conductive bumps 30. However, optically transmissive substrate 102 may differ from substrate 12 in that thin film optical material 104 may be applied to a surface of substrate 102, for example, second surface 22 of substrate 102, as shown in Fig. 2. Thin film optical material 104 may be a filter material and/or antireflective material, for example, an antireflective thin film coating. Similar to the characteristics of the filter material integrally provided with substrate 12 of first exemplary assembly 10, optical material 104 may provide selective transmissivity of a desired wavelength range.

Lens mount 18 providing support for lens 34 or other optical elements. Lens mount 18 may also be coupled to thin film optical material 104, or second surface 22 of substrate 102 if thin film optical material 104 is instead attached to first surface 20 of substrate 102. Alternatively, thin film optical material 104 may be provided attached to both first and second surface 20 and 22 of substrate 102, each material layer having a desirable property, i.e., filtering or antireflection.

The process of assembling optical sensor assembly 10 or 100 according to the present invention includes providing an optically transmissive substrate 12 or 102 having an integral filter material as described for first or second exemplary optical sensor assembly 10 and 100 above. Circuit member 14 may be attached to first surface 20 of substrate 12 or 102.

Flip chip or other mounting of integrated circuit 16 to substrate 12 or 102 is provided so that optical imaging element 24 and electrically conductive pads 28 face first surface 20 of substrate 12 or 102. Pads 28 may be electrically and mechanically coupled to circuit members 14 by using conductive bumps and thermocompression, reflow, or other known assembly processes.

Optically transmissive medium 32 may provide an underfill, encapsulant, or other typical property for integrated circuit 16 for joining integrated circuit 16 with substrate 12 or 102. If desired, lens mount 18 supporting lens 34 or other optical elements may be coupled to substrate 12 or 102 or a thin film layer thereof, for example, thin film optical material 104. Lens 34 is positioned relative to integrated circuit 16 so that radiation is directed to optical sensing element 24.

Although described in the exemplary embodiments, it will be understood that various modifications may be made to the subject matter without departing from the intended and proper scope of the invention. Accordingly, it will be understood that other optical devices incorporating an embodiment of the optical system and methods may fall within the scope of this invention, which is defined by the appended claims.

## Claims

1. An optical sensor circuit assembly (10, 100) having an optically transmissive substrate (12, 102), and an optical imaging element (24) coupled to the substrate, the assembly **characterized by** the optically transmissive substrate including filter material.

2. The optical sensor circuit assembly of claim 1, **characterized in that** said filter material is embedded in the substrate.

3. The optical sensor circuit assembly of claim 1, **characterized in that** said filter material is dispersed in the substrate.

4. The optical sensor circuit assembly of claim 1, **characterized in that** said filter material comprises a thin film layer (104) on the substrate.

5. The optical sensor circuit assembly of claim 4, **characterized in that** said thin film layer further comprises material having antireflective properties.

6. The optical sensor circuit assembly of claim 1, **characterized by** a circuit member (14) coupled to a first surface (20) of the substrate, said circuit member defining a plurality of electrically conductive leads.

7. The optical sensor circuit assembly of claim 6, **characterized in that** the optical imaging element includes an integrated circuit (16) and a plurality of electrically conductive pads (28), said plurality of pads coupled with corresponding ones of said plurality of leads.

8. The optical sensor circuit assembly of claim 7, **characterized by** a conductive bump (30) disposed between said plurality of leads and said plurality of pads.

9. The optical sensor circuit assembly of claim 1, **characterized by** at least one optical element (34) positioned to direct electromagnetic radiation through the substrate and filter material and to said optical imaging element.

10. The optical sensor circuit assembly of claim 9, **characterized by** a lens mount (18) supporting said at least one optical element and coupled to a second surface of the substrate.

11. An optical sensor circuit assembly (100) having an optically transmissive substrate (102) and an integrated circuit (16) having a face (26) including an optical imaging element (24), the assembly **characterized by** a film of optical material (104) being coupled to the substrate, and the face (26) of the integrated circuit being coupled with at least one of the substrate and said optical material.

12. The optical sensor circuit assembly of claim 11, **characterized in that** said film of optical material comprises at least one of a filter and antireflective material.

13. The optical sensor circuit assembly of claim 11, **characterized in that** said thin film optical material comprises an antireflective material; and the optically transmissive substrate comprises a filter material embedded or dispersed in the substrate.

14. The optical sensor circuit assembly of claim 11, **characterized in that** the integrated circuit further comprises a plurality of electrically conductive pads (28), and **characterized by**:
a circuit member (14) coupled to the substrate, said circuit member defining a plurality of electrically conductive leads (15); and
a plurality of conductive bumps (30) disposed between said plurality of leads and said plurality of pads.

15. The optical sensor circuit assembly of claim 11, **characterized by** at least one lens (34) positioned to direct electromagnetic radiation through the substrate and filter material and to the optical imaging element.

16. The optical sensor circuit assembly of claim 15, **characterized by** a lens mount (18) supporting said at least one optical element and coupled to a second surface of the substrate.

17. A method of assembling an optical sensor assembly, including the steps of providing an optically transmissive substrate (12, 102), coupling an integrated circuit (16) including an optical imaging element (24) with the optically transmissive substrate, and positioning the integrated circuit so that the optical imaging element faces the substrate, the method **characterized by** the step of associating a filter material or an antireflective material with the optically transmissive substrate.

18. The method of claim 17, **characterized by** the step of coupling a circuit member (14) to the substrate, and **characterized in that** the step of coupling an integrated circuit with the optically transmissive substrate includes coupling the optical imaging element to the circuit member using conductive bumps (30).

19. The method of claim 17, **characterized by** the steps of coupling an optical element to the substrate using a lens mount (18).
